# EUROPÄISCHE PATENTSCHRIFT

(11) **EP 0 373 248 B1**
(45) Veröffentlichungstag und Bekanntmachung des Hinweises auf die Patenterteilung: **09.06.1993**
(21) Anmeldenummer: 88121012.4
(22) Anmeldetag: 15.12.1988
(51) Int. Cl.: G01R 21/00

(54) **Drehstrom-Schaltungsanordnung für die netzsynchrone Zeitsteuerung eines elektrischen Gerätes**
Rotary-current circuit for the supply-synchronised time control of an electrical apparatus
Circuit à courant triphasé pour le contrôle temporel, synchronisé sur le réseau, d'un appareil électrique

(43) Veröffentlichungstag der Anmeldung: 20.06.1990
(73) Patentinhaber: SIEMENS AKTIENGESELLSCHAFT, 80333 München (DE)
(72) Erfinder: Dohmstreich, Wolfgang, Dipl.-Ing- (FH), D-8560 Lauf (DE); Steinmüller, Günter, Dipl.-Ing. (FH), D-8500 Nürnberg (DE)

(56) Entgegenhaltungen:
- AU-B- 464 218
- DE-A- 2 834 881
- DE-A- 3 719 439
- FUNKSCHAU, Band 16, 1985, Seiten 53-54, Franzis Verlag, München, DE; R. SCHIFFEL: "Grundschaltungen der Elektronik, Optokoppler, G8, Teil 1"

## Beschreibung

Die Erfindung betrifft eine Drehstrom-Schaltungsanordnung für die Zeitsteuerung eines elektrischen Gerätes nach dem Oberbegriff des Patentanspruchs 1.

Ein solches Gerät kann beispielsweise ein sogenanntes Tarifgerät sein, wie es in der DE-AS 24 46 602 beschrieben ist. Es dient der fortlaufenden Erfassung und Anzeige eines über konstante Zeitintervalle gemittelten Wertes des elektrischen Energieverbrauchs. Solche Geräte werden häufig an Drehstromnetzen betrieben und über ein Drehstromnetzteil versorgt. Solche Geräte funktionieren in der Weise, daß entsprechend der gemessenen elektrischen Arbeit Impulse erzeugt und über eine bestimmte Zeit gespeichert werden. Sie bilden das Integral der Leistung über die Zeit und sind somit ein Maß für die dem Netz entnommene elektrische Arbeit. Es werden demzufolge Impulse konstanter Frequenz als Zeitbasis benötigt, die aus der Netzfrequenz abzuleiten sind.

Auch sogenannte Maximumwächter haben eine ähnliche Arbeitsweise, wie dies in der DE-AS 26 05 803 im einzelnen beschrieben ist. Auch solche Geräte werden aus dem zugeordneten Netz versorgt und beziehen aus diesem Netz auch die Taktimpulse für die Zeitbasis.

Um aus einem Drehstromnetz eine für die Impulsbildung geignete Steuerwechselspannung abzuleiten, wird diese bei einem Vierleiternetz üblicherweise aus der Phasenspannung, d.h. der Spannung einer Phase gegen den Nulleiter, gewonnen. Bei einem Dreileiternetz dient dazu die verkettete Spannung (Phase gegen Phase). Dies hat zur Folge, daß bei einem Ausfall derjenigen Phase, die für die Steuerwechselspannung herangezogen wird, das Gerät zwar noch ausreichend mit Strom versorgt wird, aber keine Taktimpulse mehr entstehen. Dadurch ist das Gerät während der Dauer des Ausbleibens der betreffenden Phasenspannung außer Betrieb.

Der Erfindung liegt die Aufgabe zugrunde, ein solches, an einem Drehstromnetz betriebenes Gerät, auch bei einem Ausfall von einer Phase oder zwei Phasen des Drehstromnetzes noch in Funktion zu halten. Es sollen, mit anderen Worten, solange Taktimpulse erzeugt werden, wie das Gerät durch ausreichende Stromversorgung in Betrieb bleibt.

Diese Aufgabe wird durch die im Patentanspruch 1 angegebene Erfindung gelöst. Dadurch ist mit einfachen Mitteln erreicht, daß die Funktion des Gerätes auch dann noch erhalten bleibt, wenn anstelle von drei nur noch zwei Phasen oder eine Phase eines Drehstromnetzes funktionieren.

Anhand eines Ausführungsbeispiels wird die Erfindung im folgenden näher erläutert. Darin zeigen:
- Fig. 1: die erfindungsgemäße Schaltungsanordnung an einem Vierleiternetz;
- Fig. 2: die Schaltungsanordnung an einem Dreileiternetz;
- Fig. 3: ein Schaltungsbeispiel für die Gewinnung von Taktimpulsen aus einem Vierleiternetz;
- Fig. 4: ein Schaltungsbeispiel für die Gewinnung von Taktimpulsen aus einem Vierleiternetz mit gleichzeitiger galvanischer Trennung; und
- Fig. 5: ein Schaltungsbeispiel für die Gewinnung von Taktimpulsen aus einem Vierleiternetz mit Signalumformung.

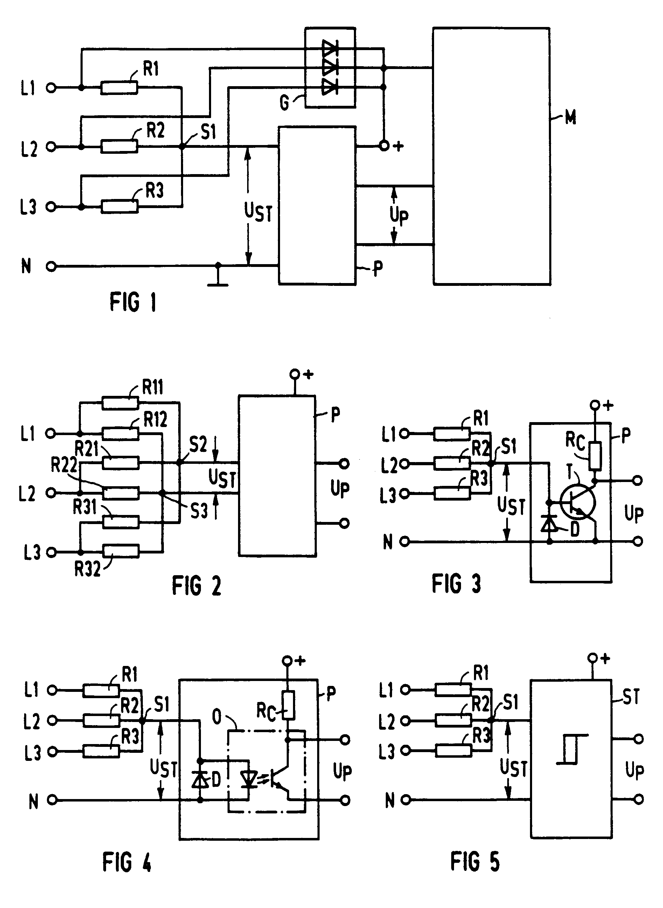

In Fig. 1 sind die Phasenanschlüsse L1, L2, L3 eines Vierleiter-Drehstromnetzes mit dem Nulleiter N über je einen Widerstand R₁, R₂, R₃ mit unterschiedlichen Widerstandswerten an einen gemeinsamen Sternpunkt S1 geführt. Zwischen diesem und dem Nulleiter tritt eine Steuerwechselspannung U_{ST} auf, die einer Impulsformerstufe P zugeführt ist. Die Amplitude der Steuerwechselspannung hängt bei konstanter Wechselspannung von den Differenzwerten der Widerstände R₁, R₂, R₃ ab. Aus dieser Steuerwechselspannung U_{ST} wird nun in der Impulsformerstufe eine Impulsfolge U_{P} gebildet, die dem elektrischen Gerät M, beispielsweise einem Maximumzähler, als Zeitbasis zugeführt ist.

Die für die Speisung der Impulsformerstufe P wie des elektrischen Gerätes M erforderliche elektrische Gleichspannung wird aus dem Drehstromnetz L1, L2, L3 durch Gleichrichten der Spannungen in einem Drehstrom-Gleichrichter G gewonnen.

Gegenüber der Herleitung der Steuerwechselspannung U_{ST} aus einer der drei Phasen des Drehstromnetzes L1, L2, L3 hat das Abgreifen der Steuerspannung U_{ST} zwischen dem aus den unsymmetrischen Widerständen R₁, R₂, R₃ gebildeten Sternpunkt S1 und dem Nulleiter N den Vorteil, daß diese auch dann noch auftritt, wenn eine Phase oder zwei Phasen des Drehstromnetzes ausgefallen sind. Das gleiche gilt für die aus allen drei Phasen gewonnene Speisegleichspannung, so daß das elektrische Gerät M auch dann noch weiterarbeitet, wenn einzelne Phasen ausfallen. Nur bei einem Gesamtausfall des Drehstromnetzes ist das Gerät nicht mehr funktionsfähig.

In Fig. 2 ist eine Variante der Schaltungsanordnung nach Fig. 1 dargestellt, die bei einem Dreiphasennetz mit Dreileiteranschluß, also ohne Nulleiter, anwendbar ist. Dabei bilden die Widerstände R₁₁, R₂₁ und R₃₁ den Sternpunkt S2 und die Widerstände R₁₂, R₂₂ und R₃₂ den Sternpunkt S3. Zwischen den beiden Sternpunkten S2 und S3 entsteht dann eine Steuerspannung U_{ST}, wenn entweder ein Sternpunkt gegenüber dem jeweils anderen unsymmetrisch ist, d.h. wenn entweder nur die den einen Sternpunkt bildenden Widerstände unterschiedliche Werte aufweisen oder wenn die Widerstände beider Sternpunkte unterschiedliche Werte aufweisen. Die so entstehende Steuerspannung U_{ST} wird auf die in Fig. 1 dargestellte und beschriebene Weise weiterverarbeitet.

In Fig. 3 ist die prinzipielle Gestaltung einer Ausführungsform für die Impulserzeugung in der Impulsformerstufe P dargestellt. Die Steuerspannung U_{ST} wird dabei einem Einweg-Gleichrichter D zugeführt, an dem eine Halbwellenspannung entsteht, die der Basis eines Schalttransistors T zugeführt ist, dessen Kollektor über einen Widerstand R_{C} mit der positiven Versorgungsspannung des Gerätes verbunden ist. Beim Auftreten jeder Spannungshalbwelle der Steuerspannung über dem Einweg-Gleichrichter D entstehen dann am Arbeitswiderstand R_{C} des des Schalttransistors die Taktimpulse.

Die in Fig. 4 dargestellte Schaltungsvariante, bei der der Schalttransistor T durch einen Optokoppler O ersetzt ist, bietet die Möglichkeit, die Impulsformerstufe galvanisch vom Drehstromnetz zu trennen.

Bei der in Fig. 5 dargestellten Schaltung tritt an die Stelle der Impulsformerstufe P gemäß der Schaltungsanordnung nach den Fig. 3 und 4 ein Schmitt-Trigger ST. Diese Schaltungsvariante kann dann angewendet werden, wenn die Taktimpulse, etwa zur Ausfilterung von Störimpulsen, eine bestimmte Form aufweisen sollen.

## Patentansprüche

1. Drehstrom-Schaltungsanordnung für die netzsynchrone Zeitsteuerung eines elektrischen Gerätes aus einem Drehstromnetz mit einem netzgeführten Impulsgeber, dessen Taktimpulse dem speisenden Drehstromnetz entnommen sind, **dadurch gekennzeichnet,** daß bei einem Drehstromnetz mit Vierleiteranschluß (3 Phasen L1, L2, L3 und Nullleiter N) drei ungleich große, in Stern geschaltete Widerstände (R₁, R₂, R₃), deren eine Enden an die zugeordneten Phasenleiter (L1, L2, L3) angeschlossen und deren andere Enden einen gegenüber dem Nulleiter (N) elektrisch symmetrischen Sternpunkt (S1) bildend miteinander verbunden sind oder daß bei einem Drehstromnetz mit Dreileiteranschluß mit Hilfe von je drei in Stern geschalteten Widerständen (R₁₁, R₂₁, R₃₁ und R₁₂, R₂₂, R₃₂), deren eine Enden gemeinsam an die zugeordneten Phasenleiter (L1, L2, L3) angeschlossen und deren andere Enden je einen Sternpunkt (S2, S3) bildend miteinander verbunden sind, und der eine Sternpunkt (S2) gegenüber dem anderen Sternpunkt (S3) durch die Wahl ungleicher Widerstandswerte der zugeordneten Widerstände elektrisch unsymmetrisch ist und die Taktimpulse aus der zwischen dem unsymmetrischen Sternpunkt (S1) und dem Nulleiter (N) oder dem ersten Sternpunkt (S2) gegenüber dem zweiten Sternpunkt (S3) auftretenden Steuerwechselspannung gebildet werden.

2. Drehstrom-Schaltungsanordnung nach Anspruch 1, **dadurch gekennzeichnet,** daß zur Impulsbildung aus der Steuerwechselspannung (U_{ST}) ein Schmitt-Trigger (ST) benutzt ist.

3. Drehstrom-Schaltungsanordnung nach Anspruch 1 oder 2, **dadurch gekennzeichnet,** daß der Impulsgeber (P) einen Optokoppler (O) enthält, der das nachfolgende Gerät (M) galvanisch vom Netz trennt.

## Claims

1. Three-phase circuit arrangement for the supply-synchronous time control of an electrical device comprising a three-phase supply with a line-commutated pulse generator, the clock pulses of which are taken from the supplying three-phase system, characterized in that in a three-phase system with four-wire configuration (3 phases L1, L2, L3 and neutral conductor N) three non-equal star-connected resistances (R₁, R₂, R₃), the one set of ends of which are connected to the associated phase conductors (L1, L2, L3) and the other set of ends of which are connected to one another to form a star point (S1) which is electrically symmetrical [sic] relative to the neutral conductor (N) or in that in a three-phase system with three-wire configuration with the aid of in each case three star-connected resistances (R₁₁, R₂₁, R₃₁ and R₁₂, R₂₂, R₃₂), the one set of ends of which are connected together to the associated phase conductors (L1, L2, L3) and the other set of ends of which are connected to one another to form a respective star point (S2, S3), and the one star point (S2) is electrically asymmetrical relative to the other star point (S3) through the selection of unequal resistance values of the associated resistances, and the clock pulses are formed from the alternating control voltage arising between the asymmetrical star point (S1) and the neutral conductor (N) or the first star point (S2) relative to the second star point (S3).

2. Three-phase circuit arrangement according to claim 1, characterized in that a Schmitt trigger (ST) is used for the pulse formation from the alternating control voltage (U_{ST}).

3. Three-phase circuit arrangement according to claim 1 or 2, characterized in that the pulse generator (P) contains an optical coupler (O) which electrically separates the subsequent device (M) from the system.

## Revendications

1. Montage électrique à courant triphasé pour la commande temporelle synchronisée sur le réseau d'un appareil électrique à partir d'un réseau triphasé, comportant un générateur d'impulsions commuté par le réseau et dont les impulsions de cadence sont prélevées du réseau triphasé d'alimentation, caractérisé en ce que, pour un réseau triphasé à branchement à quatre fils (3 fils de phases L1, L2, L3 et un fil neutre N), trois résistances (R₁, R₂, R₃) de valeurs différentes, montées en étoile, sont reliées, par les unes de leurs extrémités aux fils de phase (L1, L2, L3) associés, alors qu'elles sont reliées entre elles par leurs autres extrémités, en formant un point d'étoile (S1) électriquement symétrique par rapport au fil neutre (N), ou en ce que, pour un réseau triphasé à un branchement à trois fils, à l'aide de respectivement trois résistances (R₁₁, R₂₁, R₃₁ et R₁₂, R₂₂, R₃₂) montées en étoile, leurs unes extrémités sont reliées en commun aux fils de phase (L1, L2, L3) associés, alors que leurs autres extrémités, en formant respectivement un point d'étoile (S2, S3) sont reliées entre elles, l'un des points d'étoile (S2) étant électriquement asymétrique par rapport à l'autre point d'étoile (S3), par le choix de différentes valeurs des résistances associées, et les impulsions de cadence étant formées à partir de la tension alternative de commande qui apparait entre le point d'étoile (S1) asymétrique et le fil neutre (N) ou entre le premier point d'étoile (S2) par rapport au deuxième point d'étoile (S3).

2. Montage électrique à courant triphasé selon la revendication 1, caractérisé en ce qu'une bascule de Schmitt (ST) est utilisé pour la formation des impulsions à partir de la tension alternative de commande (U_{ST}).

3. Montage électrique à courant triphasé selon la revendication 1 ou 2, caractérisé en ce que le générateur d'impulsions (P) comprend un optocoupleur (O) qui sépare galvaniquement du réseau l'appareil suivant (M).
